# EUROPEAN PATENT SPECIFICATION

(11) **EP 0 331 360 B1**
(45) Date of publication and mention of the grant of the patent: **02.02.1994**
(21) Application number: 89301815.0
(22) Date of filing: 24.02.1989
(51) Int. Cl.: H01L 39/24, C30B 11/00, C30B 29/22

(54) **Method of preparing an oxide high-temperature superconducting material**
Verfahren zur Herstellung eines hochtemperaturoxid supraleitenden Werkstoffs
Procédé de préparation d'un matériau supraconducteur à haute température de type oxide

(30) Priority: 26.02.1988 JP 42047/88; 02.03.1988 JP 47474/88; 12.04.1988 JP 89442/88
(43) Date of publication of application: 06.09.1989
(73) Proprietor: HITACHI, LTD., Chiyoda-ku, Tokyo 100 (JP)
(72) Inventor: Kumagai, Teruo, Naka-gun Ibaraki-ken (JP); Kanai, Tsuneyuki, Hitachi-shi (JP); Soeta, Atsuko, Mito-shi (JP); Suzuki, Takaaki, Katsuta-shi (JP); Higashiyama, Kazutoshi, Katsuta-shi (JP); Kamo, Tomoichi, Naka-gun Ibaraki-ken (JP); Matsuda, Shinpei, Naka-gun Ibaraki-ken (JP); Maeda, Kunihiro, Hitachi-shi (JP); Okayama, Akira, Hitachi-shi (JP); Kodama, Hideyo, Katsuta-shi (JP); Yoshinari, Akira, Katsuta-shi (JP); Yanai, Yoshimi, Hitachi-shi (JP)
(74) Representative: Paget, Hugh Charles Edward

(56) References cited:
- EP-A- 0 308 892
- WO-A-89/08330
- ADVANCED CERAMIC MATERIALS- CERAMIC SUPERCONDUCTORS, vol. 2, no. 3B, July 1987, pages 457-470, ACerS, Westerville, OH, US; I.-W. CHEN et al.: "Superconductivity and the tailoring of lattice parameters of the compound YBa2Cu3Ox"
- JAPANESE JOURNAL OF APPLIED PHYSICS/Part 2: LETTERS, vol. 27, no. 2, February 1988, pages L185-L187, Tokyo, JP; M. OKADA et al.: "Fabrication of Ag-sheathed Ba-Y-Cu oxide superconductor tape"
- ADVANCED CERAMIC MATERIALS- CERAMIC SUPERCONDUCTORS, vol. 2, no. 3B, July 1987, pages 388-400, ACerS, Westerville, OH, US; R.W. McCALLUM et al.: "Problems in the production of YBa2Cu3Ox superconducting wire"

## Description

The Present invention relates to a method of preparing an oxide high-temperature superconducting material, more particularly an oxide high-temperature superconducting powdery or crystalline material having an excellent orientability, useful for example for making a superconducting wire having an improved critical current density.

Applications of superconductive materials are in general classified into two fields: a heavy electric engineering field suitable for high current and strong magnetic field; and a light electric engineering field suitable for low current or low voltage.

Most of prior superconductors are not practically applied. As materials for superconducting wires are known intermetallic compounds such as Nb₃Sn, Nb₃Ge, a Nb-Ti alloy and etc. These compounds have a low temperature of exhibiting superconductivity, so-called critical temperature Tc. The highest critical temperature is 23 K for Nb₃Ge. Liquid helium (4.2 K) is needed for cooling Nb₃Ge.

Recently, oxide superconducting substances having a high critical temperature Tc have been found, for example, a La-Sr-Cu oxide (35 - 40 K) and Y-Ba-Cu oxide (90 - 100 K). The critical temperature of this Y-Ba-Cu oxide is much higher than the temperature of liquid nitrogen (77 K). Thus, expensive liquid helium used for cooling the prior intermetallic compounds is not necessary to use for cooling the Y-Ba-Cu oxide. That is, the Y-Ba-Cu oxide can exhibit superconductivity with inexpensive liquid nitrogen. Therefore, the Y-Ba-Cu oxide has been noted as practical superconducting substance and is required to be put into practical use.

As high-temperature superconducting substances having a much higher superconducting transition temperature than that of prior superconducting substances, a lanthanum-barium-copper oxide was discovered by Dr. J. G. Bednorz and Dr. K. A. Müller in the beginning of 1986 (see Z. Phys. B Condesed Matter 64, 1986, pp. 189-193), and then an yttrium-barium-copper oxide (referred to as Y-Ba-Cu oxide) discovered by Dr. Chu of Houston University, U.S.A., in the spring of 1987 (see Physical Review Letters, Vol. 58, No. 9, 1987, pp. 908-910) and at the same time also in Japan (see Japanese Journal of Applied Physics, Vol. 26, No. 4, 1987, pp. L314-L315). Now intensive researches and developments have been made on a basic science about compositions, crystal structures, properties and theory of the superconducting substances, on the synthesis and applications to heavy or light electric engineering fields of superconducting substances, and further on survey of materials having superconductivity at a higher temperature, e.g., room temperature.

Among techniques to be researched and developed, a technique of making wires from the superconducting substances is important as an elemental technique in applications to the heavy electric engineering for superconductive magnets or etc.

In one of the most general methods of making wires or ribbons from Y-Ba-Cu oxide, a metal sheath is filled with an Y-Ba-Cu oxide powder and worked by a swaging machine or drawbench to be formed in the wire or by a roll machine to be formed in the ribbons. The wires or ribbons are fired at about 900°C for a few hours to sinter the Y-Ba-Cu oxide powder which otherwise will not form any current path therein, thereby allowing the particles to diffuse in each other so that the current path can be formed.

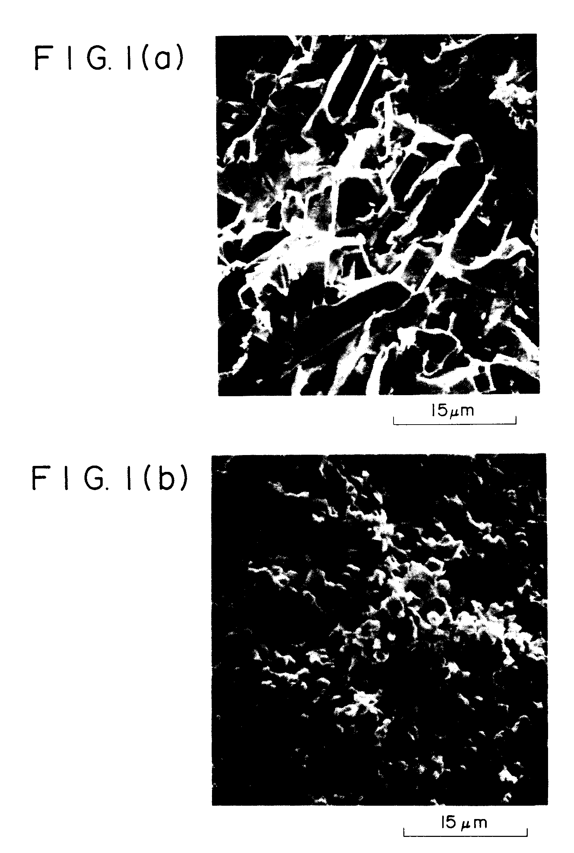

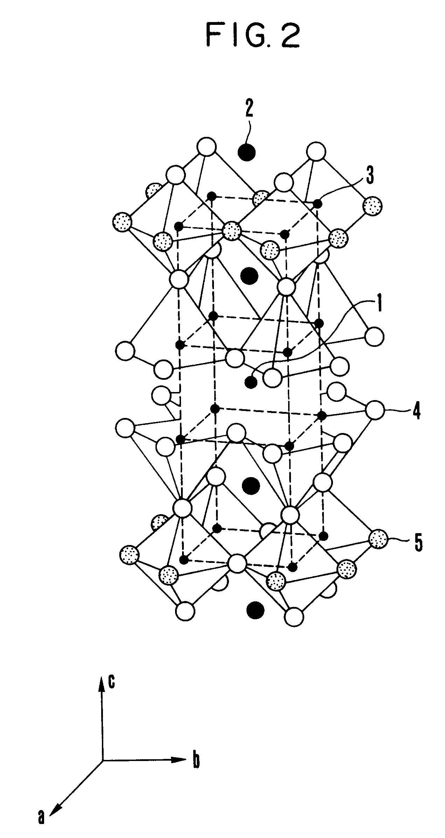

The thus obtained superconductor has a perovskite type layer crystal structure. This structure of the Y-Ba-Cu oxide superconductor is schematically illustrated in Fig. 2 attached hereto. In Fig. 2, 1 is yttrium, 2 barium, 3 copper, 4 oxygen and 5 oxygen (vacant). Electric current flows in the layers of crystal, that is, electrons can easily flow on the a axis-b axis plane of crystal (see Journal of the Japan Metal Society, Vol. 26. No. 10, 1987, p. 971). Therefore, it is important to align crystals so that the a axis-b axis planes of the crystals orient to the longitudinal direction of the wire.

From the viewpoint of this orientation, a melt-quenching method (see Symposium of Superconducting Substance Chemistry, Oct., 1987) and a chemical vapor depositing method (see Japanese Patent KOKAI(Laid-Open) No. 57-118002) have been studied. For example, a thin superconducting film having an excellent orientability has already been obtained by the chemical vapor depositing method. Such thin superconducting film has a high critical current density Jc of 10³ A/cm² as is generally required. However, this method cannot produce a long film or wire.

The metal superconducting material is relatively easily drawn into a wire but, on the other hand, the oxide superconducting material is poor in ductility and formed into wire with difficulty. Therefore, for making wires from the oxide superconducting material it is necessary to fill a metal pipe with a powder of the oxide superconducting material, draw the pipe and heat treat the drawn pipe to sinter the oxide superconducting material. However, as mentioned above, this oxide superconducting material taking the perovskite type crystal structure is anisotropic in the electric current-flowing direction. Furthermore, since this oxide has a layer structure, the crystal particles are in a plate form and hardly aligned in a direction as compared with the thin film. Therefore, current hardly flows between the particles, which prevents the critical current density Jc from being raised up. Furthermore, the orientation of crystals has not been taken into account in prior art. Therefore, crystal grains of the Y-Ba-Cu oxide grow at random and they are not oriented, so that low critical current density is obtained.

The critical current density at the temperature of liquid nitrogen (77 K) of the Y-Ba-Cu oxide produced by prior methods is now about 2,000 A/cm², as reported in Nikkan Kogyo Shimbun dated October 7, 1987.

Generally, this oxide superconducting material can be obtained by blending powders of Y₂O₃ (yttrium oxide), BaCO₃ (barium carbonate) and CuO (copper oxide) so that the ratio of Y:Ba:Cu is 1:2:3, calcining these powders at about 900°C, pulverizing and pelletizing the calcined powder, firing the pellets at about 950°C for a few hours. The thus obtained superconducting material has a critical temperature of 90 K class and is comprised of crystal particles having a particle size of a few microns, and it contains a great amount of 〈110〉 twin crystals. This is because this material has a phase transformation at about 650°C between the high-temperature phase in a tetragonal form and the low-temperature phase in a rhombic form. Therefore, when this material goes down from the high-temperature zone through the zone of this phase transformation temperature, the twin is introduced in order to compensate the change of volume between both the crystal forms.

This superconducting material is now being put into practical use as wires, but the problems are as follows:
(1) the critical current density Jc, that is, the upper current density required to maintain the superconductive state is low, and (2) the critical magnetic field Hc, that is, the upper intensity of magnetic field required to extinguish the superconductive state is low.

The principal reason why the Jc is low is that there are present areas having a superconducting property Tc at the heterogeneous portions such as grain boundaries lower than in the grain bodies. The reason why the Hc is low is that the crystal anisotropy of Hc is high and when a magnetic field is applied in a direction normal to the a axis-b axis plane (c plane), Hc is about one-fifth (1/5) lower than when the field is applied in a direction parallel to the c-plane. The Hc of entire polycrystals in which grains are oriented at random depends upon the Hc of only the grains of which the c plane is oriented to the direction parallel to the magnetic field applied. Therefore, one approach for solving these problems concerning the Jc and Hc is to grow the crystals of superconducting materials in a direction of the a axis-b axis plane (c plane) thereof and another to form a single crystal.

Hitherto, a method of making the single crystal of superconducting material is, for example, a flux method using CuO as a flux, which is discussed in Japanese Journal of Applied Physics, Vol. 26, 1987, p. L1645. In this method CuO and LnBa₂Cu₃Oₓ, wherein Ln is Y or a rare earth element, are mixed at a CuO:LnBa₂Cu₃O molar ratio of about 1:3, heated to 1,200°C and cooled at a rate of about 5°C/hr to obtain a single crystal of about 1 mm square in size. The single crystal made by using CuO as a flux (if desired, BaO may be used together as a flux) has a crystal size as small as about 1 mm square and contains a great amount of 〈110〉 twins.

In this flux method, the single crystals grow in the CuO flux and hence they are hardly removed from the flux. Furthermore, this flux method has such a defect that it is not applicable to general methods, i.e., a Bridgeman method or floating zone method (FZ method), because they use raw materials of stoichiometrical composition.

Generally, when an oxide superconducting raw material having a stoichiometric composition of LnBa₂Cu₃Oₓ is molten by heating to 1,200°C, it is decomposed into a liquid phase and a solid phase of Ln₂Ba₁Cu₁Oₓ. Even if this melt is cooled at a rate of 5°C/hr, only a few crystals having LnBa₂Cu₃Oₓ in a superconducting phase of an oxygen-deficient trilayer perovskite type structure (referred to as a (123) structure) can be obtained and rather a major of the crystals formed is of an insulating phase (referred to as a (211) structure), which is a so called non-congruent material. Thus, the superconducting phase can only be obtained in an amount of about 10 percent of the entire crystal phase. Furthermore, the size of the crystals obtained is very small, i.e., at most only about 50 µm.

Therefore, a mere melting and cooling of raw materials having a stoichiometric composition of LnBa₂Cu₃Oₓ may obtain small crystals only and not form the LnBa₂Cu₃Oₓ crystals.

In the abovementioned prior technique, crystals are grown using CuO as a flux, but they are not only as small as about 1 mm square in size but also they contain an indefinite number of 〈110〉 twins in an interval of 0.2 µm, and thus no true single crystals can be obtained. Furthermore, the Bridgeman method and FZ method are not applicable since they obtain only a small amount of superconducting phase.

It is mentioned also that WO-A-89/08330 (published 8 September 1989, forming part of the prior art under Article 54(3) EPC) discloses the preparation of an oxide superconducting material of the composition YBa_{2-y}Cu₃Oₓ where y is 0 to 0.3, in the presence of an alkali metal compound which disappears from the superconducting material on heating. This is stated to aid the orientation of the superconducting material crystals.

The object of the invention is at least partly to overcome these problems of the prior art.

One advantage of the present invention is to provide a high-temperature oxide superconducting article containing crystals improved in orientability so that the article has a high critical current density Jc.

A second feature of the present invention is to provide powdery raw materials for a high-temperature oxide superconducting material.

Another advantage of the present invention is to provide a superconducting oxide single crystal free of 〈110〉 twins.

A further advantage of the invention is to provide a method of aligning particles of the superconducting oxide materials in a predetermined direction.

The method of the invention is set out in claim 1.

Figs. 1(a) and 1(b) are electron microphotographs showing the shape of particles in articles made of high-temperature oxide superconducting powdery materials in an embodiment of the present invention and a comparative example, respectively.

Fig. 2 is a schematical view of an oxygen-deficient trilayer perovskite type structure of YBa₂Cu₃O_{y}.

Fig. 3(a) and 3(b) are X-ray diffraction patterns of shaped articles made of the oxide superconducting powdery materials in an embodiment of the present invention and a comparative example, respectively.

Fig. 4(a) and 4(b) are X-ray diffraction patterns of the oxide superconducting powdery materials in another example of the present invention and a comparative example, respectively.

Fig. 5(a) and 5(b) are electron microphotographs showing the shape of particles in articles made of high-temperature oxide superconducting powdery materials in a further example of the present invention and a comparative example, respectively.

In order to achieve the objects mentioned above, the present inventors considered that the oxide superconducting powdery material charged in a metal sheath should have an excellent orientability to a longitudinal direction of a wire or ribbon when the material is drawn or rolled in the wire or ribbon. As a result of their study, they have found that the orientation of crystals can be made easy by heat treating the oxide in the presence of bismuth.

In the present invention, the desired high critical current density can be obtained not only by improving the orientability of crystals in the oxide superconducting material, but also by providing a single crystal by solidifying a melt of the oxide superconducting material having a stoichiometric composition of LnBa₂Cu₃Oₓ wherein Ln is Y or a rare earth metal, in the presence of bismuth.

Preferably, the raw materials for the oxide superconducting material are passed through a zone comprising a high-temperature area and a low-temperature area, from the high-temperature area to the low-temperature area.

In accordance with the present invention, for example the high-temperature oxide superconducting material having a composition of LnBa₂Cu₃Oₓ, wherein Ln is yttrium or a rare earth element and x is 6.5 to 7, for example, YBa₂Cu₃O_{7-δ} is synthesized in the presence of bismuth to thereby promote the growing of crystal grains.

In actual procedures, there are two methods: a first one in which the raw materials for the oxide superconducting material are subjected to solid phase diffusion in the presence of bismuth at a temperature below the melting point of the raw materials and a second one in which the raw materials are firstly completely molten and then solidified or subsequently heat treated to grow the crystals under action of bismuth. The effectiveness of bismuth is the same in both these methods. That is, in both methods, the growing of the crystals is conspicuously promoted.

The first method above will be explained below with an example of the material having the oxygen-deficient trilayer perovskite type structure of YBa₂Cu₃O_{7-δ} containing potassium, the same explanation applying to the use of bismuth in accordance with the invention. The addition of potassium is carried out by a powder mixing method, impregnating method or coprecipitating method to raw materials or the oxide of YBa₂Cu₃O_{7-δ}. The potassium is added in the form of a compound such as potassium nitrate or carbonate. Then, the powder containing the potassium is shaped, heat treated and sintered.

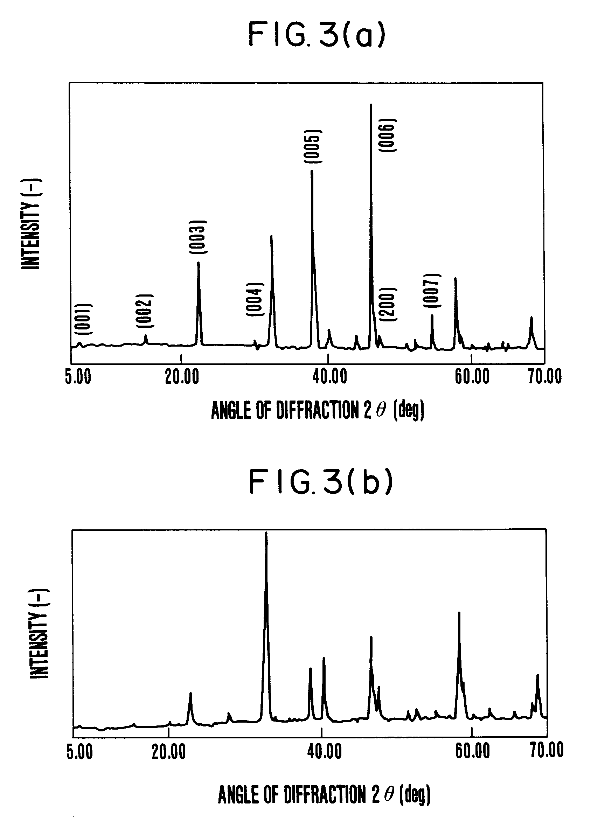

Powdery raw materials (Y₂O₃ for Y, BaCO₃ for Ba, CuO for Cu and K₂CO₃ for K) were processed in such a manner as mentioned above to prepare a shaped body. This body was observed by an electron microscope (SEM). Fig. 1(a) shows a result of observation. For comparison, Fig. 1(b) shows a result of observation of a body from raw materials free of potassium. The body from the raw materials containing potassium is seen to contain well-grown crystals as compared with the body from the raw materials free of potassium. The X-ray diffraction patterns of the surfaces of the shaped bodies are shown in Figs. 3(a) and 3(b) for the bodies containing potassium and free of potassium, respectively. The body containing potassium has an X-ray diffraction pattern intensified at (00n) planes. The potassium content of this body is a few percents of the originally incorporated content. This shows that the presence of potassium causes plate-like particles of YBa₂Cu₃O_{7-δ} to grow in a direction of crystal (a axis-b axis plane) in which electric current can easily flow, and the potassium itself disappears.

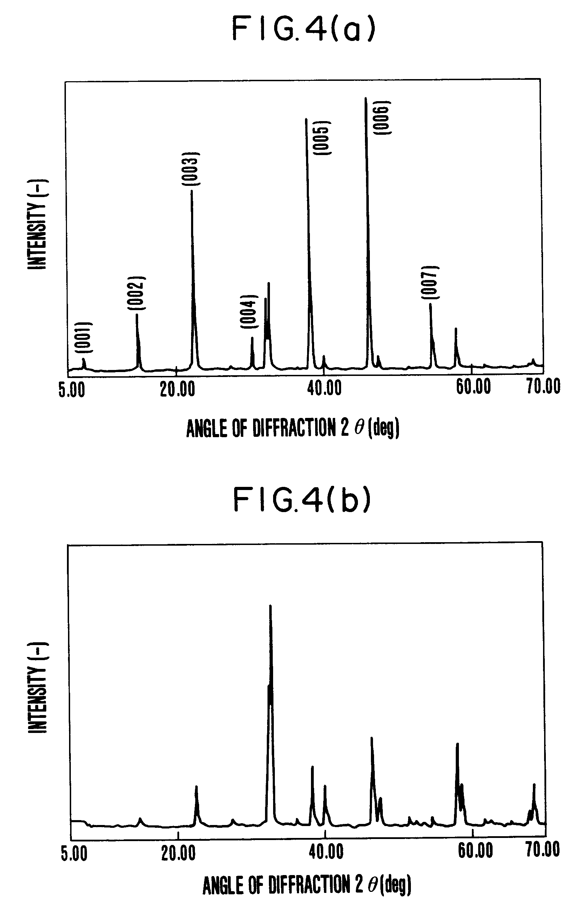

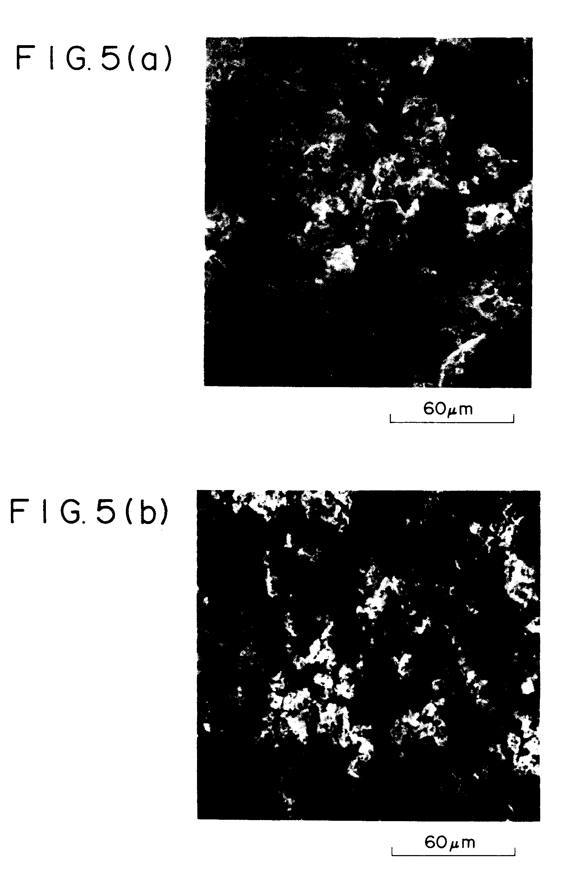

This body is in a shape of flake when cleaved by mechanical pulverization, as is seen from the X-ray diffraction pattern intensified at (00n) plane, as shown in Fig. 4(a) and the electron microphotograph by SEM observation as shown in Fig. 5(a). For comparison, the X-ray diffraction pattern and the SEM photograph of the body free of potassium are shown in Figs. 4(b) and 5(b), respectively. As is seen from Figs. 4(b) and 5(b), the body free of potassium contains small sized plate-like particles, which are in an aggregated form. The abovementioned pulverization may be carried out by various methods with, for example, a grinder (mortar and pestle) or a ball mill. The degree of pulverization is preferably such that the (00n) plane is intensified in the powder X-ray diffraction pattern.

In making a superconducting material from the thus obtained powdery material in, for example, a thin wire or ribbon, a metal pipe is filled with the powdery material (i.e., a superconducting powder containing a) grown crystals and b) potassium), and the pipe is drawn and/or rolled in the wire or ribbon. Furthermore, the powdery material is applied in a form of tape-like film on a substrate and the plate-like particles of the material can be aligned in parallel with the longitudinal direction of the tape-like film by applying a force to the film in a direction normal to the film by rolling, thereby raising up the critical current density Jc of the film.

The explanation above refers to the case of potassium but the same applies for bismuth which is used in the present invention.. The heat treating temperature may be not higher than the temperature of decomposition of the compound of bismuth but is lower than the temperature of decomposition of the oxygen-deficient layer perovskite type structure, i.e., in the range of 400 to 1,100°C, desirably 850 to 1,000°C.

The methods as mentioned above have the following advantages:
(1) the presence of bismuth promotes the crystal growing of plate-like particles in an a axis-b axis plane direction in an oxide superconducting material such as YBa₂Cu₃O_{7-δ}, LaSrCuO or BiSrCaCu₂O;
(2) the mechanical pulverization of the superconducting material gives flake-like particles each cleared at the (00n) plane so that excellent alignment of particles along the c-plane is expected; and
(3) a superconductor having an excellent orientability and a high critical current density can be obtained.

The present inventors have found that the a axis-b axis plane of crystals of a high-temperature oxide superconducting material can be oriented to the longitudinal direction of a long superconducting article by firing the material under specified conditions.

In this method, the oxide superconducting material of LnBa₂Cu₃Oₓ is fired through a zone comprising a high-temperature area and a low-temperature area by passing the material from the low-temperature area to the high-temperature area.

The high temperature area is preferably in the range of 850°C to the melting point of the oxide superconducting material, and the low temperature area is preferably in the range of not higher than 150°. The distance between the high-temperature area at the maximum temperature and the low-temperature area at the minimum temperature is preferably 80mm or less. The material is preferably heat treated while being travelled through the zone at a rate of 0.2 mm/hr to 50 mm/hr.

After this heat treatment, the material is preferably heated and annealed in an oxygen atmosphere at a temperature of 950°C or lower, thereby further improving the superconducting properties such critical temperature Tc and critical current density Jc.

The oxide superconducting material, LnBa₂Cu₃Oₓ, may be formed singly or in combination with a metal sheath. In the case that the material is in a wire form, it is preferably used in combination with the metal sheath.

When particles are fired, diffusion initially occurs between the particles in contact with each other to thereby allow the particles to bond each other at the contact surfaces thereof. Subsequently, crystal growth takes place while the diffusion goes on. In the prior art, the particles are heated to the same temperature as a whole. Therefore, the diffusion occurs throughout the whole of the particles, so that the size of the crystal grains developed in the fired particles varies depending upon the temperatures and hours used in the firing. In this case, each of the crystal grains is not restrained from growing in arbitrary direction. Therefore, the directions of adjacent crystal grains are entirely disordered.

In accordance with this preferred method of the present invention, the oxide superconducting material is passed at a low speed through a zone comprising a high-temperature area and a low-temperature area and having a short distance and a large temperature gradient between the two areas, this gradient being from the high-temperature area to the low-temperature area. The crystal grains go on growing in the travelling direction while the particles are being sintered in the high-temperature area. As a result, the crystal grains can be oriented.

The temperatures of the high-temperature area and the low-temperature area, travelling speed and the distance between the two areas have an influence on the crystal growth. In the high temperature area, the atoms of the particles diffuse from one particle to another ; high temperatures promote the diffusion. The temperature is preferably in the range of 850°C to the melting point of the superconducting material. In the low temperature area, it is required that the diffusion progresses at a very low rate. The temperatures are preferably at the highest 150°C and should be as low as possible. The travelling speed is an important factor for securing the firing action and the crystal growth. If the speed is too high, continuous crystal growth is prevented. Therefore, it is preferably at the most 50 mm/hr but it is suitably at least 0.2 mm/hr. If it is lower than 0.2 mm/hr, the effect reaches saturation. The distance between both the areas should not exceed 80 mm, in order that the crystal growth cannot be discontinued.

The resultant crystals may be in a tetragonal form depending upon the cooling rate. In such case, in order to convert the form to a rhombic form, the crystals are required to be heated and anneled in an oxygen atmosphere at temperature of 950°C or lower to absorb a sufficient amount of oxygen into the crystals, thereby providing the superconducting properties.

In an alternative method of improving the superconducting properties, the present inventors have made a single crystal growing in an a axis-b axis plane direction.

In order to improve the superconducting properties, part of Ba in the stoichiometric composition of LnBa₂Cu₃Oₓ may be effectively replaced with 0.01 to 1 mol of bismuth.

In accordance with the method of the present invention, the oxide superconducting raw material prepared above having the stoichiometric composition of LnBa₂Cu₃Oₓ, wherein Ln is at least one element selected from the group consisting of Y and rare earth metals, Together with bismuth added to this raw material, is heated to form a melt, which is then solidified.

The melt is effectively solidified in one direction.

A wire or film may be made while solidifying the melt. The film is made by dipping a substrate having a higher melting point than the temperature of the melt and less reactivity with the melt into the melt and forming the film on the substrate.

The abovementioned oxide superconducting raw material containing bismuth is heated to a temperature of 1050 to 1500°C to form the melt and this melt is effectively cooled at a cooling rate of 1 to 300°C/hr.

The oxide superconducting material prepared according to the present invention can be used in various applications. For example, the big size single crystal may be formed in a wafer and a high density heat beam is applied onto the wafer to destroy a part of the wafer, thereby forming a wiring pattern on the wafer.

Furthermore, the single crystal according to the present invention may be subjected to a magnetic field to cause the transition from superconduction to normal conduction, thereby making a switching action for a large electric current.

The present invention will be illustrated below with reference to some examples. However, the present invention is not limited to these examples.

### Example 1

5.7 grs of yttrium oxide, 11.9 grs of copper oxide, 19.7 grs of barium carbonate and 5.5 grs of bismuth oxide were mixed in a grinder (mortar and pestle) and pelletized to form pellets of 30 mm in diameter and 3 mm in thickness. These pellets were prefired at 900°C for 3 hours and pulverized. The resultant powder was pelletized and fired in oxygen at 930°C for 5 hours. These pellets were pulverized in agate mortar and subjected to SEM observation and X-ray diffraction analysis. Crystal growth and the intensification of peaks of (00n) planes were found.

A sample of 2 mm x 20 mm x 1 mm was cut from the pellets. The critical temperature and critical current density at 77 K of this sample were determined by a usual four-terminal resistance method. Tc onset was 94 K and Jc was 1,580 A/cm².

### Example 2

5.7 grs of yttrium oxide, 11.9 grs of copper oxide, 19.7 grs of barium carbonate, 2.7 grs of bismuth oxide and 0.8 gr of potassium carbonate were mixed and pelletized in the same manner as in Example 1, and fired at 900°C for 3 hours and then pulverized. The resultant powder were pelletized in the same manner as in Example 1 and fired in oxygen at 930°C for 5 hours. The resultant pellets were pulverized in the same manner as in Example 1. The resultant powder was subjected to SEM observation and X-ray diffraction analysis. Crystal growth and the peak intensification at (00n) planes were found. The superconducting properties were determined in the same manner as in Example 1. Tc onset was 93 K and Jc was 1,720 A/cm² at 77 K.

In the invention, in the method using a melt of stoichiometric composition and the fluxing method, a substrate having a melting point higher than the temperature of the melt and relatively inert to the melt may be dipped in the melt, maintained in the melt for a predetermined time and removed out from the melt to obtain a superconducting film with ease.

Furthermore, superconducting fibers for wires may be prepared by extruding the melt of stoichiometric composition through a nozzle. Of course, the size of crystal grains varies depending upon preparation conditions.

The single crystal prepared according to the present invention is suitable for studying on the properties of materials and practical applications of materials.

In the case of using the melt of stoichiometric composition, a single crystal having a large diameter can also be prepared by the Bridgeman method or FZ method. This big size single crystal can be subjected to, for example, ion-implantation or laser beam-irradiation to break part of the crystal and allow the crystal to lose the superconductivity at the part, thereby patterning electronic circuits on the crystal to form a circuit board.

## Claims

1. A method of preparing a high-temperature oxide superconducting material comprising mainly a phase of LnR₂Cu₃Oₓ wherein Ln is yttrium or a rare earth metal(s), R is at least one element selected from the group consisting of barium, calcium and strontium and x is 6.5 to 7, which comprises synthesizing said material in the presence of bismuth to form said material containing crystal grains or crystals free of any twins oriented so that the a axis - b axis planes of the crystals are substantially oriented in the current-carrying direction.

2. A method according to claim 1, wherein said oxide superconducting material is of an oxygen-deficient layer perovskite type structure.

3. A method according to claim 1 or claim 2 wherein raw materials for said oxide superconducting material are passed through a zone comprising a high-temperature area and a low-temperature area, from the low-temperature area to the high-temperature area, to orient the crystal grains in a predetermined direction.

4. A method according to claim 3, wherein said high-temperature area has a temperature in the range of 850°C to the melting point of said oxide superconducting material, said low-temperature area has a temperature in the range of up to 150°C, and the distance between said high-temperature area and said low-temperature area is not more than 80 mm.

5. A method according to claim 3 or 4, wherein said raw materials are passed through said zone at a rate of 0.2 mm/hr to 50 mm/hr.

6. A method according to any one of claims 3 to 5 wherein said oxide superconducting material is formed singly or in combination with a metal sheath.

7. A method according to claim 1 or 2 wherein said oxide superconducting material is synthesized by solidifying a melt of raw materials.

8. A method according to claim 1 or claim 2 wherein said high-temperature oxide superconducting material is prepared in a single crystal form, the method comprising melting the raw materials for the oxide superconducting material in the presence of bismuth and solidifying the melt.

9. A method according to claim 8 wherein said melt is solidified in a predetermined direction.

10. A method according to claim 8 or 9, wherein said melt is solidified to make a superconducting wire.

11. A method according to claim 8 or 9, wherein said melt is solidified by dipping a substrate having a higher melting point than the temperature of said melt and less reactivity with said melt into said melt to make a film on said substrate.

12. A method according to any one of claims 8 to 11 wherein the oxide superconducting material has the composition LnBa₂Cu₃Oₓ.

## Patentansprüche

1. Verfahren zum Herstellen eines Oxidmaterials mit Hochtemperatur-Supraleitung mit hauptsächlich einer Phase aus LnR₂Cu₃Oₓ in der Ln Yttrium oder ein Seltenerdmetall (oder Seltenerdmetalle) ist, R mindestens ein Element aus der Gruppe aus Barium, Calcium und Strontium ist, und x zwischen 6,5 und 7 liegt, bei dem das Material in Anwesenheit von Wismut synthetisiert wird, um das Material so auszubilden, daß es Kristallkörner oder Kristalle enthält, die frei von Zwillingen sind, und die so ausgerichtet sind, daß die Ebenen mit der a-Achse/b-Achse der Kristalle im wesentlichen in Stromtransportrichtung ausgerichtet sind.

2. Verfahren nach Anspruch 1, bei dem das supraleitende Oxidmaterial Perovskitschichtstruktur mit Sauerstoffmangel aufweist.

3. Verfahren nach Anspruch 1 oder Anspruch 2, bei dem die Ausgangsmaterialien für das supraleitende Oxidmaterial durch eine Zone mit einem Hochtemperaturbereich und einem Niedertemperaturbereich vom Niedertemperaturbereich zum Hochtemperaturbereich hindurchgeleitet werden, um die Kristallkörner in einer vorgegebenen Richtung auszurichten.

4. Verfahren nach Anspruch 3, bei dem der Hochtemperaturbereich eine Temperatur im Bereich von 850°C bis zum Schmelzpunkt des supraleitenden Oxidmaterials hat, der Niedertemperatur eine Temperatur im Bereich bis zu 150°C hat und der Abstand zwischen dem Hochtemperaturbereich und dem Niedertemperaturbereich nicht größer als 80 mm ist.

5. Verfahren nach einem der Ansprüche 3 oder 4, bei dem die Ausgangsmaterialien mit einer Geschwindigkeit von 0,2 mm/h bis 50 mm/h durch die Zone hindurchgeführt werden.

6. Verfahren nach einem der Ansprüche 3 bis 5, bei dem das supraleitende Oxidmaterial einzeln oder in Kombination mit einer Metallhülle ausgebildet wird.

7. Verfahren nach einem der Ansprüche 1 oder 2, bei dem das supraleitende Oxidmaterial dadurch synthetisiert wird, daß eine Schmelze der Ausgangsmaterialien zum Erstarren gebracht wird.

8. Verfahren nach Anspruch 1 oder Anspruch 2, bei dem das Oxidmaterial mit Hochtemperatur-Supraleitung in einkristalliner Form hergestellt wird, wobei die Ausgangsmaterialien für das supraleitende Oxidmaterial in Anwesenheit von Wismut geschmolzen werden und die Schmelze zum Erstarren gebracht wird.

9. Verfahren nach Anspruch 8, bei dem die Schmelze in einer vorgegebenen Richtung zum Erstarren gebracht wird.

10. Verfahren nach einem der Ansprüche 8 oder 9, bei dem die Schmelze zum Herstellen eines supraleitenden Drahts zum Erstarren gebracht wird.

11. Verfahren nach einem der Ansprüche 8 oder 9, bei dem die Schmelze dadurch zum Erstarren gebracht wird, daß ein Substrat mit höherem Schmelzpunkt als der Temperatur der Schmelze und geringem Reaktionsvermögen zur Schmelze in dieselbe eingetaucht wird, um einen Film auf dem Substrat auszubilden.

12. Verfahren nach einem der Ansprüche 8 bis 11, bei dem das supraleitende Oxidmaterial die Zusammensetzung LnBa₂Cu₃Oₓ aufweist.

## Revendications

1. Procédé pour préparer un matériau supraconducteur formé d'un oxyde à haute température comprenant principalement une phase de LnR₂Cu₃Oₓ, dans laquelle Ln désigne l'yttrium ou des métaux des terres rares, R est au moins un élément choisi dans le groupe comprenant le baryum, le calcium et le strontium et x est compris entre 6,5 et 7, qui comprend la synthèse dudit matériau en présence de bismuth pour la formation dudit matériau contenant des grains cristallins ou des cristaux exempts de macles, orientés de telle sorte que les plans axe a - axe b des cristaux sont orientés essentiellement dans la direction de circulation du courant.

2. Procédé selon la revendication 1, dans lequel ledit matériau supraconducteur formé d'un oxyde possède une structure du type perovskite à couche présentant un manque d'oxygène.

3. Procédé selon la revendication 1 ou 2, selon lequel on fait passer des matières premières pour ledit matériau supraconducteur formé d'un oxyde dans une zone comprenant un espace à haute température et un espace à basse température, de l'espace à basse température vers l'espace à température élevée, afin d'orienter les grains cristallins dans une direction prédéterminée.

4. Procédé selon la revendication 3, selon lequel ledit espace à haute température possède une température située dans la gamme comprise entre 850°C et le point de fusion dudit matériau supraconducteur formé d'un oxyde, ledit espace à basse température possède une température située dans la gamme s'étendant jusqu'à 150°C, et la distance entre ledit espace à haute température et ledit espace à basse température n'est pas supérieure à 80 mm.

5. Procédé selon la revendication 3 ou 4, selon lequel lesdites matières premières traversent ladite zone à une vitesse comprise entre 0,2 mm/h et 50 mm/h.

6. Procédé selon l'une quelconque des revendications 3 à 5, selon lequel ledit matériau supraconducteur formé d'un oxyde est formé seul ou en combinaison avec une gaine métallique.

7. Procédé selon la revendication 1 ou 2, selon lequel ledit matériau supraconducteur formé d'un oxyde est synthétisé par solidification d'une masse fondue de matières premières.

8. Procédé selon la revendication 1 ou 2, selon lequel ledit matériau supraconducteur formé d'un oxyde à haute température est préparé sous une forme monocristalline, le procédé consistant à faire fondre les matières premières pour le matériau supraconducteur formé d'un oxyde, en présence de bismuth et faire solidifier la masse fondue.

9. Procédé selon la revendication 8, selon lequel on solidifie ladite masse fondue dans une direction prédéterminée.

10. Procédé selon la revendication 8 ou 9, selon lequel on solidifie ladite masse fondue pour former un fil supraconducteur.

11. Procédé selon la revendication 8 ou 9, selon lequel on solidifie ladite masse fondue en immergeant, dans ladite masse fondue, pour former une pellicule sur ledit substrat, un substrat possédant un point de fusion supérieur à la température de ladite masse fondue et une réactivité réduite vis à vis de ladite masse fondue.

12. Procédé selon l'une quelconque des revendications 8 à 11, selon lequel le matériau supraconducteur formé d'un oxyde possède la composition LnBa₂Cu₃Oₓ.
